Europäisches Patentamt

European Patent Office

Office européen des brevets

(11) Publication number: **0 244 874**
A2

# EUROPEAN PATENT APPLICATION

(21) Application number: **87106721.1**

(22) Date of filing: **08.05.87**

(51) Int. Cl.⁴: **C 23 C 14/06**, C 23 C 16/32,
C 23 C 14/56, C 03 C 17/22

(30) Priority: **08.05.86 JP 105539/86
19.09.86 JP 221682/86
28.02.87 JP 46260/87**

(43) Date of publication of application: **11.11.87**
**Bulletin 87/46**

(84) Designated Contracting States: **DE FR GB NL SE**

(71) Applicant: **Kabushiki Kaisha Meidensha, 1-17,
Ohsaki 2-chome, Shinagawa-ku Tokyo 141 (JP)**

(72) Inventor: **Hayashi, Masao, 9-23-806, Shirako 2-chome,
Wako-shi Saitama-ken (JP)**
Inventor: **Haba, Masanori, 14-13,
Fuseshinmachi 4-chome, Kashiwa-shi Chiba-ken (JP)**

(74) Representative: **Dipl.-Phys.Dr. Manitz Dipl.-Ing.,
Dipl.-Wirtsch. Finsterwald Dipl.-Chem.Dr. Heyn
Dipl.-Phys. Rotermund Morgan, B.Sc.(Phys.),
Robert-Koch-Strasse 1, D-8000 München 22 (DE)**

(54) Luminescent material, process for producing it and luminescent semiconductor device using it.

(57) An amorphous, carbonaceous material is produced by a process comprising the steps of: supplying sputtering gas, such as $H_2$ gas or mixed gas including $H_2$ and argon gases or doping agent, to the interior of a vacuum vessel so as to maintain the pressure inside the vacuum vessel at 133.3 mPa to $6 \times 133.3$ Pa; applying high-frequency A.C. or direct current voltage between a graphite target and a counter electrode which are provided in the vacuum vessel; and depositing an amorphous, carbonaceous material on a substrate disposed in the vacuum vessel, the substrate being maintained at a temperature less than or equal to 100 °C.

LUMINESCENT MATERIAL, PROCESS FOR PRODUCING IT AND LUMINESCENT SEMICONDUCTOR DEVICE USING IT

## BACKGROUND OF THE INVENTION

(FIELD OF THE INVENTION)

The present invention relates to a luminescent material, a process for producing it and luminescent semiconductor device using it. More specifically, the invention relates to a luminescent material comprising an amorphous, carbonaceous material.

(DESCRIPTION OF THE PRIOR ART)

As is well known, GaAs, GaAsP, GaP, GaAlAs, $ZnSe_xTe_{1-x}$, $Zn_xCd_{1-x}Te$, CdTe and so forth, which are raw materials of light-emitting diodes, have been used as luminescent materials.

However, these conventional luminescent materials have specific, intrinsic luminescent wavelengths and optical energy gap. For example, the peak wavelength of GaP is 698nm and the optical energy gap thereof is 1.76 eV. Therefore, when the luminescent characteristic of a luminescent device to be used must be changed, a luminescent material used therein, which has a desired peak wavelength and optical energy gap, must be selected.

## SUMMARY OF THE INVENTION

It is therefore a principle object of the present invention to eliminate the aforementioned disadvantage and to provide a luminescent material, of which the optical energy gap and the luminescent characteristic can be selected, and a process for producing it. Another object of the invention is to provide a luminescent semiconductor device, which can use the above-mentioned luminescent material so as to display its full luminescent characteristic, and a process for producing it.

In order to accomplish the aforementioned and other specific objects, a luminescent material, according to the present invention, comprises an amorphous, carbonaceous material which is produced by a sputtering process.

According to one aspect of the invention, a luminescent material is produced by a process comprising the steps of:

supplying sputtering gas to the interior of a vacuum vessel so as to maintain the pressure inside the vacuum vessel at 133.3 mPa to 6 x 133.3 Pa;

applying voltage between a graphite target and a counter electrode which are provided in the vacuum vessel; and

depositing an amorphous, carbonaceous material on a substrate disposed in the vacuum vessel, the substrate being maintained at a temperature less than or equal to $100^{\circ}$C.

In this case, the voltage applied between the

- 2 -

grahite target and the counter electrode may be high-frequency voltage or direct current voltage. In addition, a $H_2$ gas or a mixed gas including $H_2$ gas and argon gas may be used as the sputtering gas. A doping agent or dopant can be added to the mixed gas. The doping agent may include at least one of diborane, phosphine and nitrogen. In addition, the substrate may comprise any one of silica glass, silicon, gold, aluminum and glass on which gold is deposited or evaporated.

According to another aspect of the invention, a luminescent semiconductor device is produced by a process comprising the steps of:

causing first low-pressure reaction gases, which include hydrocarbon gas, silicon hydride gas and p-type impurity gas, to perform first glow-discharge in a vacuum vessel so as to form a hole-injected layer, which includes a p-type amorphous silicon carbide film, on a substrate provided in the vacuum vessel by way of plasma chemical vapor deposition;

supplying low-pressure sputtering gas to the interior of the vacuum vessel, in which a carbonaceous material target is provided, to cause the sputtering gas to perform sputtering so as to form a luminescent layer, which includes an amorphous, carbonaceous material, on the substrate; and

causing second low-pressure reaction gases, which include hydrocarbon gas, silicon hydride gas and n-type impurity gas, to perform glow-discharge in the vacuum vessel so as to form an electron-injected layer, which includes a n-type amorphous silicon carbide film, on the substrate by way of plasma chemical vapor depositon.

In this case, a hydrogen gas may be used as the sputtering gas. Preferably, hydrocarbon gas is methane gas. Electrical power used in the glow-discharge and the sputtering may be high-frequency electrical power. The pressure inside the vacuum vessel is preferably maintained less than or equal to 66.7 Pa (0.5 Torr). In addition, $B_2H_6$ gas may be used as the p-type impurity gas and $PH_3$ gas may be used as the n-type impurity gas.

## BRIEF DESCRIPTION OF THE DRAWINGS

The present invention will be understood more fully from the detailed description given herebelow and from the accompanying drawings of the preferred embodiment of the invention. The drawings are not intended to imply limitation of the invention to this specific embodiment, but are for explanation and understanding only.

In the drawings:

Fig.1 is a schematic view of a sputtering apparatus used in the production of a luminescent material according to the present invention;

- 4 -

Fig. 2 is a graph showing the luminescent characteristic of luminescent materials produced under various hydrogen pressure;

Fig. 3 is a graph showing optical energy gaps of the luminescent materials;

Figs. 4 and 5 are graphs showing infrared spectra of the luminescent materials;

Fig.6 is a graph showing the relationships between the optical energy gap and partial pressure of argon in a vacuum vessel used in the sputtering apparatus;

Fig. 7 is a graph showing luminescent characteristics of the luminescent materials;

Fig. 8 is a graph showing the relationship between the optical energy gap $E_0$ and the photo luminescence PL of amorphous, carbonaceous film of the invention;

Fig. 9 is a schematic view of the preferred embodiment of a luminescent semiconductor device according to the invention;

Fig. 10 is a schematic view of a manufacturing apparatus of the luminescent semiconductor device; and

Fig. 11 is a graph showing luminescent characteristic of a diode using a luminescent material of the invention.

**DESCRIPTION OF THE PREFERRED EMBODIMENT**

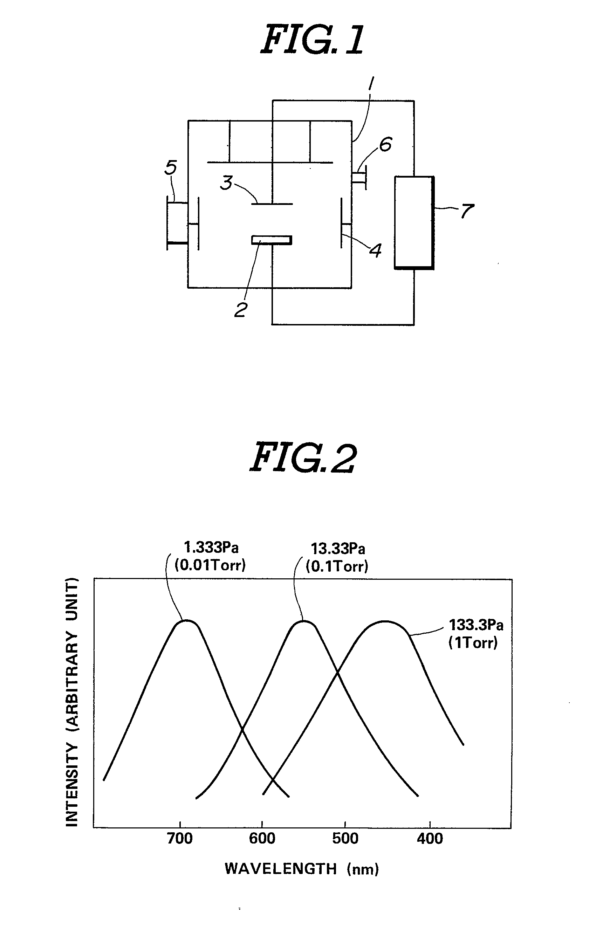

Referring now to the drawings, particluraly to Fig. 1, a sputtering apparatus used in the production of a luminescent material, according to the present invention, is schematically described. The sputtering apparatus includes a metallic vacuum vessel 1. In the interior of the vacuum vessel 1, a graphite target 2 having 75 mm of diameter and a counter electrode 3, which is separated from the graphite target 2 by a distance of 20 mm, are provided. In order to prevent sputtering particles from causing ion-bombardment, a substrate holder 4 is mounted on the inner wall of the vacuum vessel 1 so as to be separated from the graphite target 2 by a predetermined distance. In addition, the vacuum vessel 1 is provided with a exhaust pipe 5, which is in communication with a vacuum pump not shown, and a gas supply tube 6 supplying surrounding gas to the vacuum vessel 1. Furthermore, the graphite target 2 is connected to one terminal of a high-frequency power supply 7 and the counter electrode 3 is connected to the other terminal of the power supply 7 so that high-frequency voltage is applied between the graphite target 2 and the counter electrode 3.

EXAMPLE 1

Using the aforementioned sputtering apparatus, sputtering was performed under the following conditions:
(1) surrounding gas and pressure

After the pressure of the vacuum vessel 1 was reduced to 13.33 $\mu$Pa, 99.99999 % pure $H_2$ was supplied to

- 6 -

the vacuum vessel 1 so that the pressure thereof was held at 133.3 Pa.

(2) high-frequency power supply

    electric power   300 W

    anode voltage   2KV

    frequency      13.56 MHz

    anode current   0.2 A

(3) spputering time    2 hours

(4) substrate

    silica glass, silicon, gold, Al

(5) temperature of the substrate   below 100$^{\circ}$C

(6) rate of formation of film   0.3 nm/min

(7) thickness of film   0.6 μm

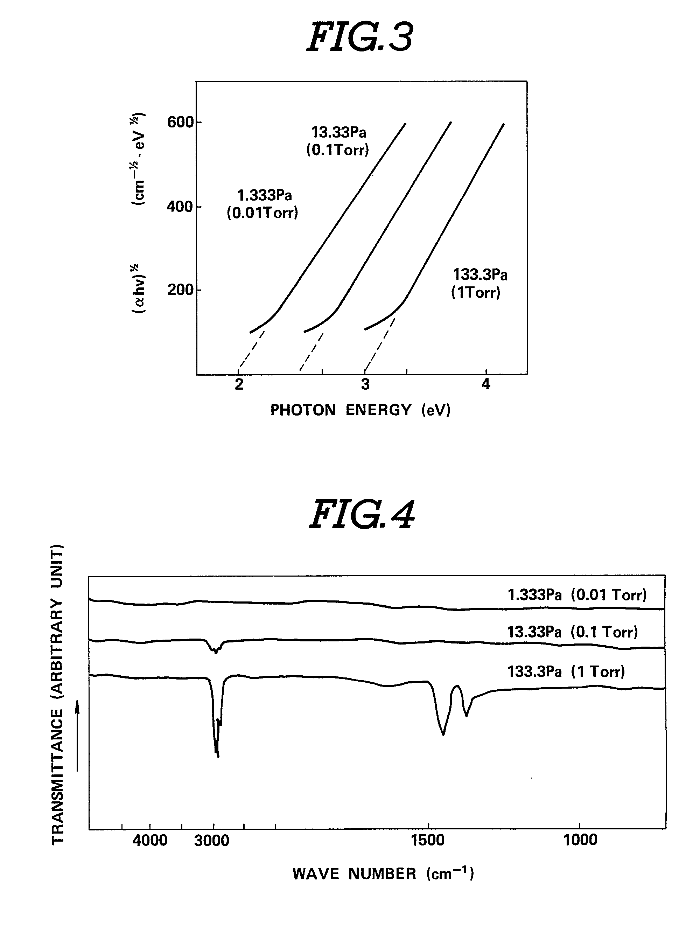

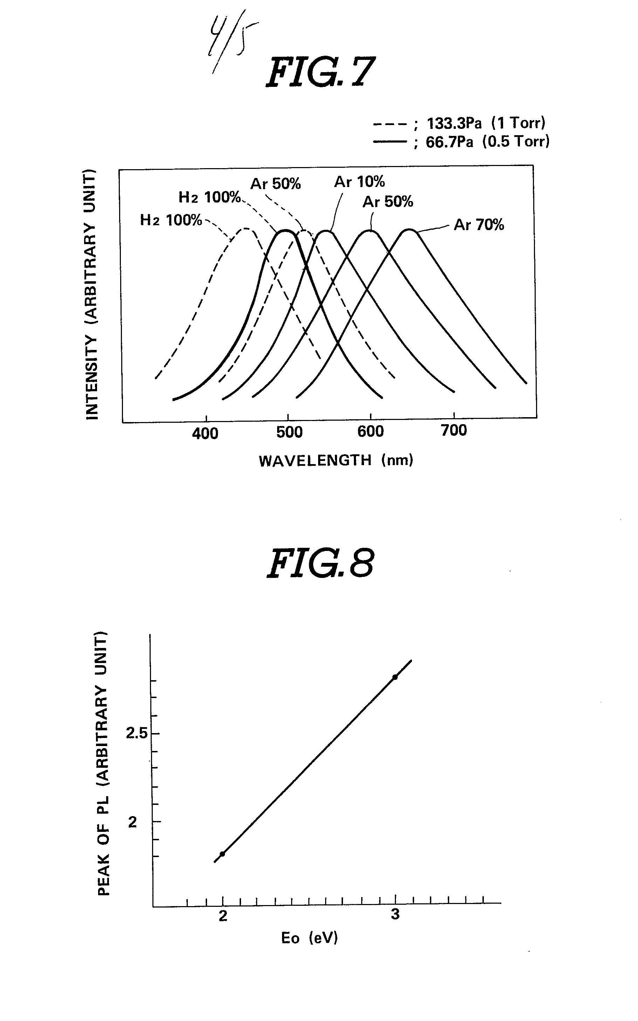

    Electron diffraction analysis was performed with repsect to an amorphous, carbonaceous film obtained under the aforementioned conditions. As a result, a halo pattern, which is a characteristic of an amorphous material, was observed. In addition, the luminescent characteristic of the film sample formed on the silica glass substrate was observed by means of a He-Cd laser (325nm). These results are shown in Figs. 2, 3 and 7. As shown in Fig. 3, the optical energy gap or band edge energy of the film was 3.0 eV. As shown in Figs. 2 and 7, the peak of the luminescence spectrum of the film is 450nm. In addition, according to an electron paramagnetic resonance, the spin density of the film was $3 \times 10^{16}/cm^3$.

**EXAMPLE 2**

Using the aforementioned sputtering apparatus, sputtering was performed under the following conditions: (1) surrounding gas and pressure

After the pressure of the vacuum vessel 1 was reduced to 13.33 $\mu$Pa, 99.99999 % pure $H_2$ was supplied to the vacuum vessel 1 so that the pressure thereof was held to be 13.33 Pa. (2) rate of formation of film 0.2 nm/min

Other conditions were similar to those of example 1.

Electron diffraction analysis was performed with repsect to an amorphous, carbonaceous film obtained under the aforementioned conditions. As a result, a halo pattern was also observed. In addition, the luminescent characteristic of the film formed on the substrate was observed by means of a He-Cd laser (325nm). These results are shown in Fig. 2. As shown in Fig. 3, the optical energy gap of the film was 2.7 eV.

**EXAMPLE 3**

Using the aforementioned sputtering apparatus, sputtering was performed under the following conditions: (1) surrounding gas and pressure

After the pressure of the vacuum vessel 1 was reduced to 13.33 $\mu$Pa, 99.99999 % pure $H_2$ was supplied to the vacuum vessel 1 so that the pressure thereof was held to be 1.333 Pa. (2) rate of formation of film 0.15 nm/min

Other conditions were similar to those of example 1.

Electron diffraction analysis was performed with repsect to an amorphous carbonaceous film obtained under the aforementioned conditions. As a result, halo pattern was also observed. In addition, the luminescent characteristic of the film formed on the substrate was observed by means of a He-Cd laser (325nm). These results are shown in Fig. 2. As shown in Fig. 2, the peak of the luminescence spectrum the film is at 690nm. And as shown in Fig. 3, the optical energy gap of the film was 2.0 eV.

According to the aforementioned examples 1 to 3, solid carbonaceous material, such as graphite and glassy carbons, or hydrocarbons can be sputtered in low-pressure hydrogen gas to form carbon or hydrocarbon ions or radical particles so that a luminescent, amorphous material, which has luminescent and semiconductor characteristics, was deposited on a substrate. The amorphous materials obtained by way of sputtering were light-yellow or essentially colorless, transparent materials and had 2.0 to 3.0 eV of optical energy gap. With respect to luminescent characteristics, various peaks in the luminescence spectra were observed between 2.8 to 1.8 eV (450 to 690 nm) in accordance with the optical energy gaps. Due to these characteristics, they can be used in practical, blue light-emitting diodes, semiconducter laser diodes, expression panels and so forth.

Fig. 4 shows infrared spectra of luminescent materials obtained in the example 1 to 3. As shown in Fig. 4, strong absorbances were observed at about 2900 $cm^{-1}$, 1460 $cm^{-1}$ and 1380 $cm^{-1}$ attribute to $C-H_n$ stretching vibrtations and deformation vibrations. As a result, it was found that amorphous, carbonaceous materials serving as luminescent materials, according to the present invention, were combined with hydrogens.

As shown in Fig.4, there is an interrelation between the hydrogen pressure and the intensity of the infrared spectrum. In addition, the integral value of the infrared spectrum in each mode depends on the amount of combined hydrogen. It was found therefore that there was an interrelation between the hydrogen pressure and the amount of combined hydrogen in the film.

Fig. 3 shows visible and ultraviolet spectra of luminescent materials obtained in the example 1 to 3. As shown in Fig. 3, the optical energy gap also depends on the hydrogen pressure. Furthermore, the maximun thereof was 3.0 eV.

As shown in Fig. 2, the peak of the luminescence spectrum were slightly less than the optical energy gaps and the maximum thereof was 2.8 eV (450nm). This value is more than that of amorphous silicon, amorphous silicon carbide and so forth which have been proposed.

EXAMPLE 4

Using the aforementioned sputtering apparatus, sputtering was performed under the following conditions:

(1) surrounding gas and pressure

After the pressure of the vacuum vessel 1 was reduced to 4 x $10^{-5}$ Pa (3 x $10^{-7}$ Torr), 99.99999 % pure $H_2$ was supplied to the vacuum vessel 1 so that the pressure thereof was held to be 66.7 Pa (0.5 Torr).

(2) substrate

silica glass, silicon, glass onto which gold is deposited or evaporated.

(3) temperature of the substrate     below 100°C

Other conditions were similar to those of example 1.

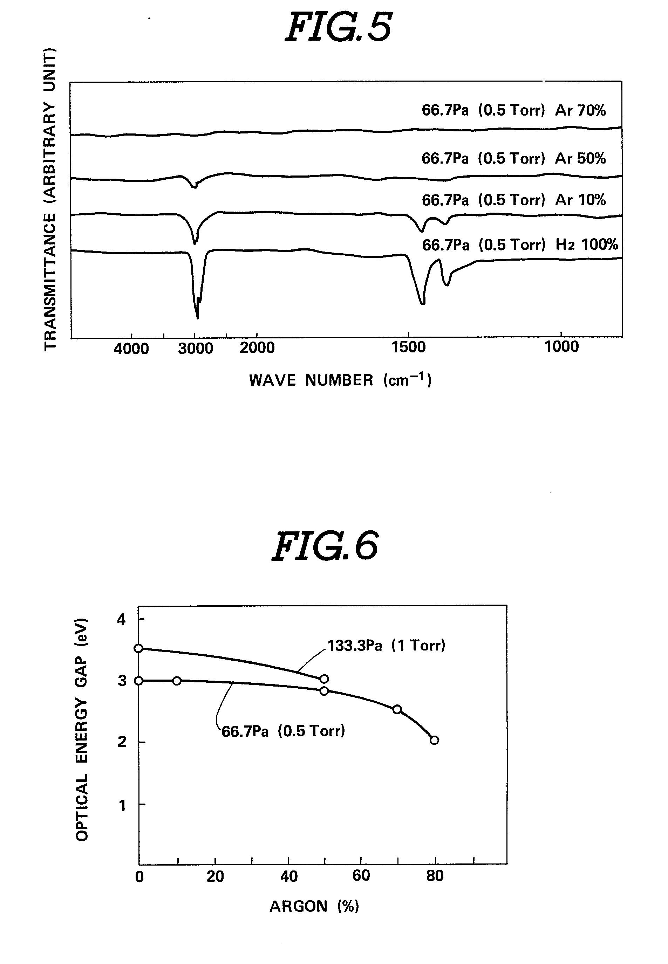

Electron diffraction analysis was performed with repsect to an amorphous, carbonaceous film obtained under the aforementioned conditions. As a result, a halo pattern was also observed. In addition, the luminescent characteristic of the film formed on the silica glass was observed by means of a He-Cd laser (325nm). As shown by broken line in Fig. 7, the peak wavelength of the luminescence spectrum of the film was 480nm. As shown in Fig. 6, the optical energy gap was 3.0 eV. In addition, according to electron paramagnetic

- 11 -

resonance, the spin density of the film was 5 x $10^{16}/cm^3$.

## EXAMPLE 5

Using the aforementioned sputtering apparatus, sputtering was performed. After the pressure of the vacuum vessel 1 was reduced to 4 x $10^{-5}$Pa (3 x $10^{-7}$ Torr), $H_2$ including 10 % argon was supplied to the vacuum vessel 1 and the pressure thereof was held at 66.7 Pa (0.5 Torr). Other conditions were similar to those of example 4. The thickness of the film obtained was 0.5 μm.

Electron diffraction analysis was performed with repsect to an amorphous, carbonaceous film obtained under the above-mentioned conditions. As a result, a halo pattern was observed. In addition, the luminescent characteristic of the film formed on the silica glass substrate was observed by means of a He-Cd laser (325nm). As shown in Fig. 7, the the peak wavelength of the luminescence spectrum thereof was 550nm. As shown in Fig. 6, the optical energy gap of the film was 3.0 eV. In addition, according to electron paramagnetic resonance, the spin density of the film was 8 x $10^{16}/cm^3$.

## EXAMPLE 6

Using the aforementioned sputtering apparatus, sputtering was performed. After the pressure of the vacuum vessel 1 was reduced to 4 x $10^{-5}$Pa (3 x $10^{-7}$

- 12 -

Torr), $H_2$ including 50 % argon was supplied to the vacuum vessel 1 so that the pressure thereof was held to be 66.7 Pa (0.5 Torr). Other conditions were similar to those of the example 4. The thickness of the film obtained was 0.4 μm.

Electron diffraction analysis was performed with repsect to an amorphous, carbonaceous film obtained under the above-mentioned conditions. As a result, a halo pattern was observed. In addition, the luminescent characteristic of the film formed on the silica glass substrate was observed by means of a He-Cd laser (325nm). As shown in Fig. 7, the the peak wavelength of the luminescence spectrum thereof was 600nm. As shown in Fig. 6, the optical energy gap of the film was 2.8 eV. In addition, according to electron paramagnetic resonance, the spin density of the film was 2 x $10^{17}/cm^3$.

EXAMPLE 7

Using the aforementioned sputtering apparatus, sputtering was performed. After the pressure of the vacuum vessel 1 was reduced to 4 x $10^{-5}$ Pa (3 x $10^{-7}$ Torr), $H_2$ including 70 % argon was supplied to the vacuum vessel 1 and the pressure thereof was held at 66.7 Pa (0.5 Torr). Other conditions were similar to those of example 4. The thickness of the film obtained was 0.3 μm.

Electron diffraction analysis was performed

- 13 -

with repsect to an amorphous, carbonaceous film obtained under the above-mentioned conditions. As a result, a halo pattern was observed. In addition, luminescent characteristic of the film formed on the silica glass substrate was observed by means of a He-Cd laser (325 nm). As shown in Fig. 7, the the peak wavelength of the luminescence spectrum thereof was 650 nm. As shown in Fig. 6, the optical energy gap of the film was 2.5 eV. In addition, according to electron paramagnetic resonance, the spin density of the film was 4 x $10^{17}/cm^3$.

EXAMPLE 8

Using the aforementioned sputtering apparatus, sputtering was performed. After the pressure of the vacuum vessel 1 was reduced to 4 x $10^{-5}$Pa (3 x $10^{-7}$ Torr), $H_2$ including 50 % argon was supplied to the vacuum vessel 1 and the pressure thereof was held to be 66.7 x 2 Pa (1.0 Torr). Other conditions were similar to that of the example 4. The thickness of the film obtained was 0.4 μm.

Electron diffraction analysis was performed with repsect to an amorphous, carbonaceous film obtained under the abovementioned conditions. As a result, a halo pattern was observed. In addition, the luminescent characteristic of the film sample formed on the silica glass substrate was observed by means of a He-Cd laser (325 nm). As shown in Fig. 7, the the peak wavelength of the luminescence spectrum thereof was 520nm. As shown in Fig. 6, the optical energy gap of the film was 3.0 eV. In addition, according to electron paramagnetic resonance, the spin density of the film was 8 x $10^{16}/cm^3$.

The amorphous materials obtained according to the example 4 to 8 by way of sputtering were light-yellow or colorless, transparent materials and had 2.0 to 3.5 eV of optical energy gap. A semiconductor can be produced from the aforementioned amorphous materials by supplying sputtering gas, such as diborane, phosphine or nitrogen, which includes elements by which doping is to be performed, and hydrogen to the sputtering apparatus.

With respect to luminescent characteristic, various peaks of luminescence spectra were observed between 1.8 to 2.8 eV (450 to 690 nm) in accordance with the optical energy gaps. Due to these charactersistics, they can be used in practical blue light-emitting diodes, semiconducter laser diodes, expression panels and so forth.

Fig. 5 shows infrared spectra of luminescent materials obtained in the example 4 to 7. As shown in Fig. 5, strong absorbances were observed at about 2900 $cm^{-1}$, 1460 $cm^{-1}$ and 1380 $cm^{-1}$ attribute to $C-H_n$ stretching vibrations and deformation vibrations. As a result, it was found that luminescent materials of the invention combined with hydrogen.

Therefore, it may be assumed that no carbon-carbon double bond exists in the luminescent materials since absorbance characteristics associated with hydrogen combined with C=C double bond was not observed at all.

In addition, Fig. 5 shows infrared spectra when the sputtering gas is a mixed gas comprising hydrogen and argon. As seen from Fig. 5, there is an interrelation between the partial pressure of argon and the intensity of the infrared spectra.

In addition, Fig. 6 shows the dependency of optical energy gap according to the partial pressure of argon. The optical energy gap also depends on the partial pressure of argon and changes from 3.5 to 2.0.

Fig. 7 shows luminescent characteristics of the samples formed under each argon partial pressure. The peaks of the luminescence spectra were slightly less than the optical energy gaps and the maximum thereof was 2.8 eV (450nm). This value is more than that of amorphous silicon, amorphous silicon carbide and so forth which have been proposed.

In addition, specific resistances of amorphous, carbonaceous materials of the invention are between $10^{14}$ and $10^{7}$ $\Omega$cm and could be changed according to percentage of doping-gas added to hydrogen and/or argon gas(es).

As mentioned above, amorphous, carbonaceous materials of the invention have large optical energy gaps, which essentially do not change up to $300^{O}C$, and relatively short peak wavelengths of luminescence spectra. In addition, since the optical energy gap and the luminescent characteristic may be selected at will according to sputtering conditions, there is an advantage in that materials having desired characteristics can be easily obtained. Films made of the luminescent materials, according to the invention, may produce strong photo luminescence (PL) in accordance with dimension of optical energy gap $(E_0)$. The relationship between $E_0$ and PL is shown in Fig. 8. Since film having about 3 eV of $E_0$ can emit blue luminescence, the luminescent materials of the invention can be used in large-area blue-luminescent panel. In addition, a luminescent semiconductor device, which can change color of emitted light from red to blue, can be produced by selecting various $E_0$. In addition, the luminescent material of the invention can be applied to a large, flat panel display.

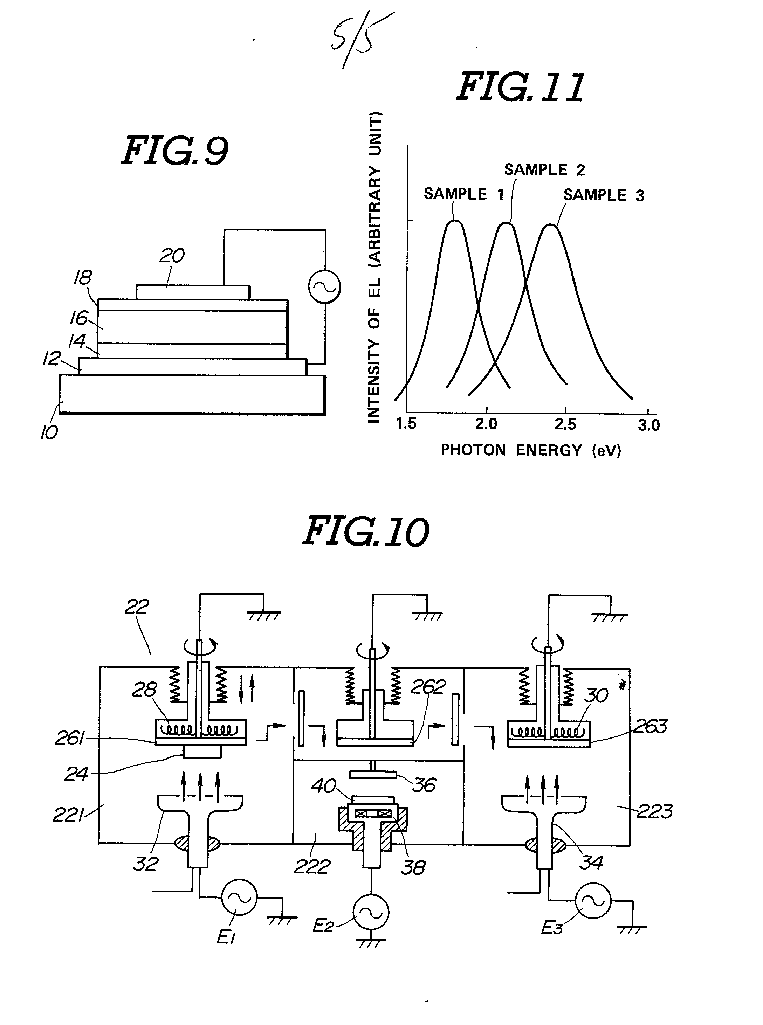

The preferred embodiment of a luminescent semiconductor device of the present invention, which uses the luminescent material of the invention, is described below. As shown in Fig. 9, the luminescent semiconductor device includes a glass substrate 10, the area of which is, for example, about 63 $cm^3$. On the

upper surface thereof, a transparent electrode 12 made of tin oxide is disposed. In addition, a hole injected layer 14 comprising a p-type amorphous silicon carbide film (a-SiC film) having about 30nm of thickness, the doping agent (dopant) of which is $B^{3+}$, is disposed on the upper surface of the transparent electrode 12. On the upper surface thereof, a luminescent layer 16 comprising an amorphous, carbonaceous film (a-C=H film) 300 nm thick is disposed. On the upper surface thereof, an electron injected layer 18 comprising n-type a-SiC film having about 50 nm of thickness, the dopant of which is $P^{5+}$, is disposed. In addition, an aluminum electrode 20 is disposed on the upper surface thereof.

Referring to Fig. 10, an apparatus for preparing the above-mentioned luminescent semiconductor device is discribed below. According to the invention, a vacuum vessel 22 is used in preparation of the luminescent semiconductor device. The vacuum vessel 22 comprises first, second and third vacuum chambers 221, 222 and 223. In the interior of the vacuum chambers 221 to 223, first, second and third susceptors 261, 262 and 263 are provided. In a first stage, a substrate 24 is fixed to the first susceptor 261. The susceptors 261 to 263 is rotatably supported by the upper wall of the vacuum vessel 22. Heaters 10 and 11 are provided above the first and third susceptors 261 and 263. The first and third vacuum chambers 221 and 223 are provided with gas supply sections 32 and 34 opposite to the susceptors 261 and 263, respectively. The gas supply sections 32 and 34 are connected to high-frequency power supplies $E_1$ and $E_3$, respectively. The second chamber 222 is provided with an anode 36 and a cathode 38 which is connected to a high-frequency power supply $E_2$. A target 40 comprising a solid carbon, such as a graphite, is disposed on the cathode 38.

Using the above-mentioned apparatus, a process for producing a luminescent semiconductor device is discribed below. A gas mixture comprising $CH_4$, $SiH_4$ and $B_2H_6$ is diluted with $H_2$ gas so as to comprise a about thirtieth of the final mixture. The diluted gas is supplied to the vacuum chamber 221. Simultaneously, high-frequency voltage is applied to the gas by means of the high-frequency power supply $E_1$ so that ionized gas formed by glow discharge is attached to the substrate 24 to form a p-type a-SiC film. In this case, the a-SiC film is formed according to a plasma CVD (Chemical Vapor Deposition) method. Thereafter, the substrate 24, onto which the a-SiC film was formed, is transferred to the second vacuum chamber 222 while the vacuum pressure is maintained in the interior of the chambers. In addition, $H_2$ gas is supplied to the second vacuum chamber 222 and simultaneously high-frequency voltage is applied to the cathode 38 by means of the power supply $E_2$. As a result, ionized particles of $H_2$ collide with

the target 40 so that an a-C=H film is formed on the upper surface of the a-SiC film. Thereafter, the substrate 24, onto which these films are formed, is transferred to the third vacuum chamber 223 while the interior of the chambers is held under vacuum pressure. Thereafter, gas mixture comprising $CH_4$, $SiH_4$ and $PH_3$, which is diluted with $H_2$ gas so as to comprise about a thirtieth of the final mixture, is supplied to the vacuum chamber 223. Simultaneously, high-frequency voltage is applied to the gas by means of the high-frequency power supply $E_3$ so that ionized gas formed by glow discharge is attached to the a-C=H film on the substrate 24 to form a n-type a-SiC film. As a result, p-i-n-type luminescent semiconductor device may be produced.

A luminescent semiconductor device, according to the invention, was produced under the following conditions:

Sample 1

(1) hole injected layer

    pressure of gas in vacuum vessel

                66.7 Pa (0.5 Torr)

    temperature of substrate        300 $^{\circ}$C

    ratio of $CH_4$ gas to $SiH_4$ gas    1 to 1

    ratio of $B_2H_6$ gas

      to ($CH_4$ gas + $SiH_4$ gas)    3 to 1000

    high-frequency electrical power    100 W

(2) luminescent layer

pressure of $H_2$ gas in vacuum vessel

66.7 Pa (0.5 Torr)

temperature of substrate      70 $^O$C

high-frequency electrical power      300 W

diameter of target      75 mm

(3) electron injected layer

pressure of gas in vacuum vessel

66.7 Pa (0.5 Torr)

temperature of substrate      300 $^O$C

ratio of $CH_4$ gas to $SiH_4$ gas    1 to 1

ratio of $PH_3$ gas

to ($CH_4$ gas + $SiH_4$ gas)      5.8 to 1000

high-frequency electricl power      100 W

(1 $W/cm^2$ relative to area of input electrode) Sample 2

(1) hole injected layer and electrode injected layer similar conditions to that of sample 1

(2) luminescent layer similar conditions to that of sample 1 except that

pressure of $H_2$ gas in vacuum vessel was 40 Pa (0.3 Torr).

Sample 3

(1) hole injected layer and electron injected layer similar conditions to those of sample 1

(2) luminescent layer similar conditions to those of sample 1 except that

- 21 -

pressure of gas in vacuum vessel was 13.3 Pa (0.1 Torr).

Example 9

An experiment was performed with respect to luminescent charcter of the samples 1 to 3 under the conditions in which forward-direction bias voltage was 5V and current density was 200 mA/cm$^2$. Relationships between wavelength and EL intensity in these samples 1 to 3 are shown in Fig. 10. It was found that these samples have superior luminescent characteristics since emission from these samples was visible. Althogh a-SiC films having 2.0eV of $E_0$ and $10^6 \Omega$cm of $\rho$ were used in the above-mentioned example, further superior luminescent characteristics can be obtained if a-SiC films having more than 2.0eV of $E_0$ and less than $10^6 \Omega$cm of $\rho$ are used. In addition, temperature of the substrate is restricted according to heat resistance of a-C=H film. The temperature must be less than or equal to about $350^{\circ}$C since $E_0$ and the thickness of the film are decreased if a-C=H film is heated above $350^{\circ}$C.

In cases where a p-i-n-type cell, in which p-type a-SiC film, a-C=H film and n-type a-SiC film are piled, is used, heterojunction between a-C=H film and p-type or n-type a-SiC film must be favorably formed, that is, holes or electrons must be satisfactorily injected from an injection layer to a luminescent layer. However, after diode characteristic of the samples 1 to 3 was examined, it was found that there are back-to-back diode characteristics so that the heterojunction is favorably formed.

While the present invention has been disclosed in terms of the preferred embodiment in order to facilitate better understanding of the invention, it should be appreciated that the invention can be embodied in various ways without departing from the principle of the invention. Therefore, the invention should be understood to include all possible embodiments and modifications to the shown embodiments which can be embodied without departing from the principle of the invention set out in the appended claims.

- 23 -

**WHAT IS CLAIMED IS:**

1.        A process for producing a luminescent material, which comprises the steps of:

supplying sputtering gas to the interior of a vacuum vessel so as to maintain the pressure inside said vacuum vessel at 133.3 mPa to 6 x 133.3 Pa;

applying voltage between a graphite target and a counter electrode which are provided in said vacuum vessel; and

depositing an amorphous, carbonaceous material on a substrate disposed in said vacuum vessel, said substrate being maintained at a temperature less than or equal to $100^{\circ}C$.

2.        A process as set forth in claim 1, wherein said voltage is high-frequency A.C. voltage or direct current voltage.

3.        A process as set forth in claim 2, wherein said amorphous, carbonaceous material is an amorphous carbon.

4.        A process as set forth in claim 2, wherein said sputtering gas is $H_2$ gas.

5.        A process as set forth in claim 2, wherein said sputtering gas is a mixed gas comprising $H_2$ gas and

argon gas.

6.    A process as set forth in claim 2, wherein said sputtering gas is a mixed gas comprising $H_2$ gas, argon gas and doping agent.

7.    A process as set forth in claim 6, wherein said doping agent is at least one of diborane, phosphine and nitrogen.

8.    A process as set forth in claim 2, wherein said substrate comprises any one of silica glass, silicon, gold, aluminum and glass on which gold is evaporated.

9.    A luminescent material produced by a process comprising the steps of:

supplying sputtering gas to the interior of a vacuum vessel and maintaining the pressure inside said vacuum vessel at 133.3 mPa to 6 x 133.3 Pa;

applying voltage between a graphite target and a counter electrode which are provided in said vacuum vessel; and

dipositing an amorphous, carbonaceous material on a substrate disposed in said vacuum vessel, said substrate being maintained at a temperature less than or equal to 100$^{O}$C.

- 25 -

10.      A luminescent material as set forth in claim 9, wherein said voltage is high-frequency A.C. voltage or direct current voltage.

11.      A luminescent material as set forth in claim 10, wherein said amorphous, carbonaceous material is an amorphous carbon.

12.      A luminescent material as set forth in claim 10, wherein said sputtering gas is $H_2$ gas.

13.      A luminescent material as set forth in claim 10, wherein said sputtering gas is a mixed gas comprising $H_2$ gas and argon gas.

14.      A luminescent material as set forth in claim 10, wherein said sputtering gas is a mixed gas comprising $H_2$ gas, argon gas and doping agent.

15.      A luminescent material as set forth in claim 14, wherein said doping agent is at least one of a diborane, a phosphine and nitrogen.

16.      A luminescent material as set forth in claim 10, wherein said substrate comprises any one of silica glass, silicon, gold, aluminum and glass on which gold is deposited.

- 26 -

17. A process for producing a luminescent semiconductor device, which comprises the steps of:

causing first low-pressure reaction gases, which include hydrocarbon gas, silicon hydride gas and p-type impurity gas, to perform glow-discharge in a vacuum vessel so as to form a hole-injected layer, which includes a p-type amorphous silicon carbide film, on a substrate provided in said vacuum vessel by way of plasma chemical vapor deposition;

supplying low-pressure sputtering gas to the interior of said vacuum vessel, in which a carbonaceous material target is provided, to cause said sputtering gas to perform sputtering so as to form a luminescent layer, which includes an amorphous, carbonaceous material, on said substrate; and

causing second low-pressure reaction gases, which include hydrocarbon gas, silicon hydride gas and n-type impurity gas, to perform glow-discharge in said vacuum vessel so as to form an electron-injected layer, which includes a n-type amorphous silicon carbide film, on said substrate by way of plasma chemical vapor depositon.

18. A process as set forth in claim 17, wherein said sputtering gas is hydrogen gas.

19. A process as set forth in claim 17, wherein electrical power used in each of said glow-discharge and said sputtering is high-frequency A.C. electrical power.

20.        A process for as set forth in claim 18, wherein electrical power used in each of said glow-discharge and said sputtering is high-frequency A.C. electrical power.

21.        A process as set forth in claim 17, wherein the pressure inside said vacuum vessel is maintained less than or equal to 66.7 Pa (0.5 Torr).

22.        A process as set forth in claim 17, wherein said p-type impurity gas is $B_2H_6$ gas.

23.        A process as set forth in claim 17, wherein said n-type impurity gas is $PH_3$ gas.

24.        A process as set forth in claim 22, wherein said n-type impurity gas is $PH_3$ gas.

25.        A process as set forth in claim 24, wherein the ratio of said hydrocarbon gas to said silicon hydride gas by volume is 1 to 1.

26.        A process as set forth in claim 25, wherein the ratio of said $B_2H_6$ gas to the mixed gas including

- 28 -

hydrocarbon gas and silicon hydride gas by volume is 3 to 1000.

27.       A process as set forth in claim 25, wherein the ratio of said $PH_3$ gas to the mixed gas including hydrocarbon gas and silicon hydride gas by volume is 5.8 to 1000.

28.       A process as set forth in claim 17, wherein said hydrocarbon gas is methane gas.

29.       A luminescent semiconductor device comprising:

a hole-injected layer, which includes a p-type amorphous silicon carbide film, produced by a process including the steps of; supplying first low-pressure reaction gases, which include hydrocarbon gas, silicon hydride gas and p-type impurity gas, to the interior of a vacuum vessel, causing said first reaction gases to perform glow-discharge in said vacuum vessel, and depositing said p-type amorphous silicon carbide by way of plasma chemical vapor deposition;

a lumicescent layer, which includes an amorphous, carbonaceous material, produced by a process including the steps of; supplying low-pressure sputtering gas to the interior of said vacuum vessel, in which a carbonaceous material target is provided, causing said sputtering gas to perform sputtering, and

- 29 -

depositing an amorphous, carbonaceous material, on said substrate; and

an electron-injected layer, which includes a n-type amorphous silicon carbide film, produced by a process including the steps of; supplying second low-pressure reaction gases, which include hydrocarbon gas, silicon hydride gas and n-type impurity gas, to the interior of said vacuum vessel, causing said second reaction gases to perform glow-discharge in said vacuum vessel, and depositing said n-type amorphous silicon carbide on said substrate by way of plasma chemical vapor deposition.

30.      A luminescent semiconductor device as set forth in claim 29, wherein said sputtering gas is hydrogen gas.

31.      A luminescent semiconductor device as set forth in claim 29 wherein electrical power used in each of said glow-discharge and said sputtering is high-frequency A.C. electrical power.

32.      A luminescent semiconductor device as set forth in claim 30, wherein electrical power used in each of said glow-discharge and said sputtering is high-frequency A.C. electrical power.

0 244 874

33.      A luminescent semiconductor device as set forth in claim 29, wherein the pressure inside said vacuum vessel is maintained less than or equal to 66.7 Pa (0.5 Torr).

34.      A luminescent semiconductor device as set forth in claim 29, wherein said p-type impurity gas is $B_2H_6$ gas.

35.      A luminescent semiconductor device as set forth in claim 29, wherein said n-type impurity gas is $PH_3$ gas.

36.      A luminescent semiconductor device as set forth in claim 34, wherein said n-type impurity gas is $PH_3$ gas.

37.      A luminescent semiconductor device as set forth in claim 36, wherein the ratio of said hydrocarbon gas to said silicon hydride gas by volume is 1 to 1.

38.      A luminescent semiconductor device as set forth in claim 37, wherein the ratio of said $B_2H_6$ gas to the mixed gas including hydrocarbon gas and silicon hydride gas by volume is 3 to 1000.

39.      A luminescent semiconductor device as set

- 31 -

forth in claim 37, wherein the ratio of said $PH_3$ gas to the mixed gas including hydrocarbon gas and silicon hydride gas by volume is 5.8 to 1000.

40.     A luminescent semiconductor device as set forth in claim 29, wherein said hydrocarbon gas is methane gas.

- 32 -

*FIG.1*

*FIG.2*

## FIG.3

(αhv)½   (cm⁻½ · eV ½)

600

400

200

13.33Pa
(0.1Torr)

1.333Pa
(0.01Torr)

133.3Pa
(1Torr)

2          3          4

PHOTON ENERGY (eV)

## FIG.4

TRANSMITTANCE (ARBITRARY UNIT)

1.333Pa  (0.01 Torr)

13.33Pa  (0.1 Torr)

133.3Pa  (1 Torr)

4000          3000                    1500                    1000

WAVE NUMBER (cm⁻¹)

3/5

## FIG.5

TRANSMITTANCE (ARBITRARY UNIT)

66.7Pa (0.5 Torr) Ar 70%

66.7Pa (0.5 Torr) Ar 50%

66.7Pa (0.5 Torr) Ar 10%

66.7Pa (0.5 Torr) H₂ 100%

WAVE NUMBER (cm⁻¹)

## FIG.6

OPTICAL ENERGY GAP (eV)

133.3Pa (1 Torr)

66.7Pa (0.5 Torr)

ARGON (%)

4/5

# FIG. 7

--- ; 133.3Pa (1 Torr)
——— ; 66.7Pa (0.5 Torr)

# FIG. 8

## FIG.9

## FIG.11

INTENSITY OF EL (ARBITRARY UNIT)

SAMPLE 2
SAMPLE 1
SAMPLE 3

1.5    2.0    2.5    3.0

PHOTON ENERGY (eV)

## FIG.10